(19) Europäisches Patentamt
European Patent Office
Office européen des brevets

(11) **EP 2 890 990 B1**

(12) **FASCICULE DE BREVET EUROPEEN**

(45) Date de publication et mention de la délivrance du brevet:
**30.09.2020 Bulletin 2020/40**

(21) Numéro de dépôt: **13762188.4**

(22) Date de dépôt: **26.08.2013**

(51) Int Cl.:
*G01R 31/52* (2020.01)     *B60L 3/00* (2019.01)
*B60L 50/51* (2019.01)     *H02K 11/20* (2016.01)
*G01R 31/00* (2006.01)

(86) Numéro de dépôt international:
**PCT/FR2013/051967**

(87) Numéro de publication internationale:
**WO 2014/033397 (06.03.2014 Gazette 2014/10)**

(54) **DISPOSITF DE DÉTÉCTION ET DE MESURE D'UN DÉFAUT D'ISOLEMENT**

VORRICHTUNG ZUM NACHWEIS UND ZUR MESSUNG EINES ISOLATIONSFEHLERS

DEVICE FOR DETECTING AND MEASURING AN INSULATION FAULT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.08.2012 FR 1258089**

(43) Date de publication de la demande:
**08.07.2015 Bulletin 2015/28**

(73) Titulaire: **Renault S.A.S.**
**92100 Boulogne-Billancourt (FR)**

(72) Inventeurs:
• **PALMIERI, Michael**
**38160 Gieres (FR)**
• **CARCOUET, Sébastien**
**38450 Vif (FR)**
• **CHATROUX, Daniel**
**38470 Teche (FR)**
• **CORDESSES, Lionel**
**78180 Montigny-Le-Bretonneux (FR)**
• **MENSLER, Michel**
**78180 Montigny-Le-Bretonneux (FR)**

(56) Documents cités:
**WO-A2-2012/036498     US-A1- 2004 212 371**

**Description**

L'invention concerne l'isolement d'un réseau ou d'une alimentation électrique à tension continue par rapport à une référence de tension.

Les systèmes électriques de forte puissance à tension continue connaissent un développement important. En effet, de nombreux systèmes de transport incluent une alimentation de tension continue.

Les véhicules hybrides combustion/électrique ou électriques incluent notamment des batteries de forte puissance. Pour obtenir le niveau de tension adéquat, on place en série plusieurs accumulateurs électrochimiques. Pour obtenir de fortes puissances et capacités, on place plusieurs groupes d'accumulateurs en série. Le nombre d'étages (nombre de groupes d'accumulateurs) et le nombre d'accumulateurs en parallèle dans chaque étage varient en fonction de la tension, du courant et de la capacité souhaités pour la batterie. L'association de plusieurs accumulateurs est appelée une batterie d'accumulateurs.

De telles batteries sont utilisées pour entraîner un moteur électrique à courant alternatif par l'intermédiaire d'un onduleur. Les niveaux de tension nécessaires pour de tels moteurs atteignent plusieurs centaines de Volts, typiquement de l'ordre de 400 Volts. De telles batteries comportent également une forte capacité afin de favoriser l'autonomie du véhicule en mode électrique. Plusieurs raisons techniques spécifiques à l'application automobile amènent à l'utilisation d'un isolement entre la masse mécanique du véhicule (formée par le châssis et la carrosserie métalliques du véhicule, et donc accessibles à l'utilisateur) et les potentiels de la batterie. La raison principale est qu'il n'est pas envisageable lors d'un premier défaut d'isolement en roulage de déconnecter instantanément la batterie de traction. Par exemple, dans le cas où l'un des pôles de la batterie est relié à la masse mécanique et que le défaut d'isolement apparaît sur l'autre pôle. Ceci se traduit par un court-circuit et la fusion immédiate du fusible de protection. Cela aurait pour effet de rendre le véhicule dangereux, du fait de la disparition de la puissance de traction ou du freinage récupératif. Ceci oblige donc à devoir isoler la batterie et surveiller cet isolement pour des raisons de sécurité des personnes par un contrôleur d'isolement. En effet, si lors d'un premier défaut il n'y a aucun risque pour l'utilisateur, il convient de l'alerter de ce premier défaut avant l'apparition d'un second défaut ayant pour effet de déconnecter la batterie de traction car provoquant un court-circuit entre les bornes positive et négative de la batterie. De plus, lors de ce second défaut, la tension de la batterie serait directement reliée à la masse mécanique du véhicule et l'utilisateur serait donc potentiellement en contact avec celle-ci. Du fait du risque potentiel d'une telle source d'énergie pour les utilisateurs, l'isolement et le contrôle de l'isolement entre la batterie et la masse mécanique doivent être particulièrement soignés. Toute partie du véhicule reliée électriquement à la batterie doit être isolée par rapport aux masses. Cet isolement est réalisé par l'utilisation de matériaux isolants. L'isolement peut se détériorer avec le temps (à cause des vibrations, des chocs mécaniques, de la poussière, etc.), et donc mettre la masse mécanique sous un potentiel dangereux.

Par ailleurs, il peut être envisagé d'utiliser un chargeur non isolé galvaniquement du réseau électrique. La masse mécanique du véhicule étant normativement reliée à la terre lors des recharges et le régime de neutre utilisé classiquement (régime TT) en résidentiel connectant le neutre à la terre, cela revient à connecter pendant les recharges la masse mécanique du véhicule à un des potentiels de la batterie. Pendant ces recharges, la tension complète de la batterie est donc appliquée aux bornes de l'isolement contrairement au cas nominal où seulement la moitié de cette tension est appliquée et surtout contrôlée. Cet isolement pourrait ne pas être capable de tenir la tension complète créant un second défaut instantanément ayant pour conséquence un court-circuit.

Un véhicule électrique selon l'état de la technique présente typiquement une batterie destinée à l'alimentation d'un moteur électrique triphasé. La batterie comprend des accumulateurs électrochimiques. Un dispositif de protection muni de fusibles est connecté aux bornes de la batterie. Un dispositif de contrôle d'isolement est également connecté aux bornes de la batterie et raccordé à la masse mécanique du véhicule. Le dispositif de contrôle d'isolement est connecté à un calculateur pour lui signaler les défauts d'isolement détectés. Ce calculateur est alimenté par une batterie de réseau de bord. Le pôle négatif de cette batterie est relié à la masse du véhicule. Les bornes de la batterie appliquent des tensions +Vbat et -Vbat sur les entrées continues d'un onduleur par l'intermédiaire d'un système de coupure. Le système de coupure comprend des contacteurs de puissance commandés par le calculateur. Le moteur électrique est connecté à la sortie alternative de l'onduleur. Différents types de contrôle d'isolement sont connus de l'état de la technique.

Du fait du vieillissement, certains matériaux d'isolement peuvent s'avérer appropriés pour supporter la tension entre la masse mécanique et une borne de la batterie en fonctionnement normal, mais peuvent claquer lorsqu'ils sont soumis à la tension totale entre les bornes de la batterie du fait d'un défaut d'isolement.

Les dispositifs de contrôle connus ne permettent pas de tester et de détecter un tel défaut d'isolement potentiel, ce qui peut conduire à des défauts d'isolement en chaîne. Un premier défaut d'isolement sur une polarité applique la tension totale entre l'autre polarité et la masse. Si l'isolement de cette autre polarité n'était pas apte à le supporter, le second défaut d'isolement apparaît. Ceci crée un court-circuit avec fusion des fusibles. Ceci correspond à une perte de traction puis une immobilisation soudaine du véhicule qui est dangereuse.

Aucun des contrôleurs d'isolement connus ne donne satisfaction avec les contraintes industrielles rencontrées. Aucun des contrôleurs d'isolement connus ne permet de détecter un défaut d'isolement, de déterminer quelle polarité de la batterie est touchée par le défaut d'isolement, de déterminer si les deux polarités sont touchées par un défaut d'isolement, de mesurer l'amplitude d'un défaut d'isolement, sans induire une consommation électrique excessive, et ce à un coût compatible avec le prix de vente attendu pour un véhicule diffusé à grande échelle auprès du public. Des contrôleurs d'isolement connus sont décrits dans WO 2012/036498 A2 et US 2004/212371 A1.

L'invention vise à résoudre un ou plusieurs de ces inconvénients. L'invention porte ainsi sur un dispositif de détection d'un défaut d'isolement d'une source de tension continue susceptible d'induire une électrocution, comprenant :

- des première et deuxième bornes d'entrée destinées à être connectées aux bornes de la source de tension;
- des premier et troisième dipôles résistifs connectés en série entre une masse électrique et la deuxième borne d'entrée, le premier dipôle résistif présentant une résistance au moins dix fois supérieure à celle du troisième dipôle ;
- un deuxième dipôle résistif et un interrupteur connectés en série entre la première borne d'entrée et la masse électrique ;
- un circuit de détection connecté aux bornes du troisième dipôle, le circuit de détection étant configuré pour :

  - ouvrir et fermer alternativement ledit interrupteur ;
  - mesurer la tension aux bornes du troisième dipôle lorsque l'interrupteur est ouvert et lorsque l'interrupteur est fermé ;
  - déterminer l'amplitude d'un défaut d'isolement en fonction des tensions mesurées.

Selon une variante, la résistance du premier dipôle est au moins trois fois supérieure à la résistance du deuxième dipôle.

Selon une autre variante, le troisième dipôle est un potentiomètre ou un réseau de résistances commutées.

Selon encore une variante, le circuit de détection ferme ledit interrupteur de façon répétée avec un intervalle temporel compris entre 2 et 30 secondes.

Selon une autre variante, le circuit de détection maintient l'interrupteur fermé avec un rapport cyclique inférieur ou égal à 2 %.

Selon encore une autre variante, ledit interrupteur inclut un optocoupleur commandé par le circuit de détection.

Selon une variante, la résistance du premier dipôle et la résistance du deuxième dipôle sont chacune au moins égales à 50kΩ.

L'invention porte en outre sur un système de motorisation, comprenant :

- un dispositif de détection tel que décrit ci-dessus ;
- une batterie dont les bornes sont connectées aux première et deuxième bornes d'entrée du dispositif de détection ;
- un onduleur présentant une interface continu et une interface alternatif, les bornes de la batterie étant connectées à l'interface continu;
- un moteur électrique connecté à l'interface alternatif de l'onduleur.

Selon une variante, la tension aux bornes de la batterie est supérieure à 100 V.

Selon une variante, le circuit de détection commande la résistance du potentiomètre de sorte que cette résistance est proportionnelle à la tension aux bornes de la batterie.

D'autres caractéristiques et avantages de l'invention ressortiront clairement de la description qui en est faite ci-après, à titre indicatif et nullement limitatif, en référence aux dessins annexés, dans lesquels :

- la figure 1 est une représentation schématique d'un exemple de véhicule à moteur électrique alimenté par batterie;
- la figure 2 est une représentation schématique d'un dispositif de détection et de mesure de défaut d'isolement selon mode de réalisation de l'invention ;
- la figure 3 illustre le dispositif de détection et de mesure de la figure 2 dans le contexte d'un premier type de défaut d'isolement ;
- la figure 4 illustre le dispositif de détection et de mesure de la figure 2 dans le contexte d'un deuxième type de défaut d'isolement ;
- les figures 5 et 6 illustrent des diagrammes de sensibilité d'un dispositif de détection en fonction de différentes valeurs de résistance ;
- les figures 7 et 8 illustrent le fonctionnement du dispositif de détection de défaut d'isolement en présence d'un double défaut ;
- les figures 9 et 10 illustrent des résultats de fonctionnement de deux variantes du dispositif de détection et de mesure de défaut d'isolement ; -les figures 11 à 14 illustrent différentes variantes de dispositifs de détection de défaut d'isolement.

L'invention propose un dispositif de détection et de mesure d'un défaut d'isolement d'une source de tension continue susceptible d'induire une électrocution. Ce dispositif comprend des première et deuxième bornes d'entrée connectées aux bornes de la source de tension.

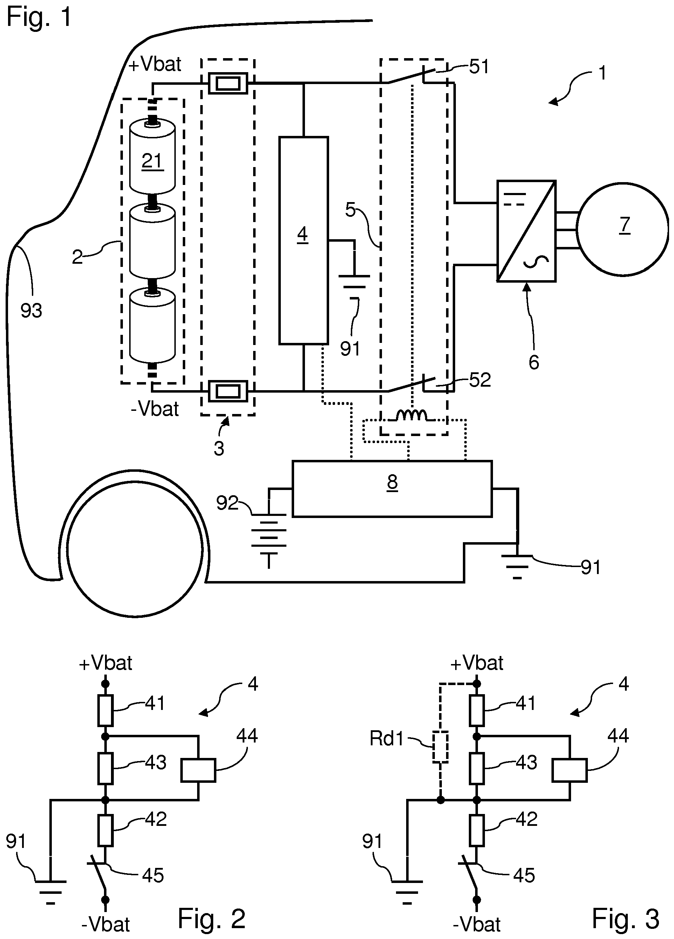

La figure 1 illustre un exemple de véhicule 1 mettant en oeuvre un mode de réalisation de l'invention. Le véhicule 1 est un véhicule électrique comprenant de façon connue en soi une batterie 2 incluant des accumulateurs électrochimiques 21 connectés en série. La batterie 2 comprend un grand nombre d'accumulateurs 21 connectés en série, typiquement entre 40 et 150 accumulateurs en fonction de la tension nécessaire et du type d'accumulateurs utilisé. La tension aux bornes de la batterie 2 chargée est typiquement de l'ordre de 400 V. La batterie 2 applique une tension +Vbat sur une première borne, et une tension -Vbat sur une deuxième borne. Les accumulateurs 21 sont connectés en série par l'intermédiaire de connexions électriques de puissance. Les bornes de la batterie 2 sont connectées à une interface continu d'un onduleur 6. Un moteur électrique 7 est connecté sur une interface alternatif de l'onduleur 6.

La connexion entre les bornes de la batterie 2 et l'interface continu de l'onduleur 6 est réalisée par l'intermédiaire d'un circuit de protection 3 et par l'intermédiaire d'un circuit d'accouplement de puissance 5. Le circuit de protection 3 peut comprendre de façon connue en soi des fusibles configurés pour ouvrir la connexion lors d'un court-circuit. Le circuit d'accouplement de puissance 5 comprend des interrupteurs 51 et 52 permettant de connecter/déconnecter sélectivement les bornes de la batterie 2 à l'interface continu de l'onduleur 6. L'ouverture/fermeture des interrupteurs 51 et 52 est commandée par un circuit de commande 8, typiquement un calculateur de supervision du fonctionnement de la batterie 2. Le circuit de commande 8 est typiquement alimenté par l'intermédiaire d'une batterie 92 d'alimentation du réseau de bord du véhicule 1, présentant un niveau de tension très inférieur à celui de la batterie 2. Le circuit de commande 8 est typiquement connecté à la masse mécanique 91, incluant le châssis et la carrosserie 93 métalliques du véhicule 1.

Un dispositif de détection et de mesure d'un défaut d'isolement 4 est connecté aux bornes de la batterie 2 et à la masse mécanique 91. Un mode de réalisation d'un tel dispositif de détection 4 est détaillé schématiquement à la figure 2.

Le dispositif de détection et de mesure 4 comporte des bornes d'entrée +Vbat et -Vbat sur lesquelles sont appliquées respectivement les tensions +Vbat et -Vbat de la batterie, par l'intermédiaire de connexions de puissance. Le dispositif 4 inclut des premier, deuxième et troisième dipôles résistifs 41, 42 et 43. Les dipôles résistifs 41 et 43 sont connectés en série entre la masse mécanique 91 et la borne d'entrée +Vbat. Le dipôle résistif 42 est connecté en série avec un interrupteur 45 entre la borne d'entrée -Vbat et la masse mécanique 91.

On notera par la suite Vbat la tension aux bornes de la batterie 2, et R1, R2 et R3 les résistances respectives des dipôles 41, 42 et 43.

Un circuit de détection et de mesure 44 est connecté aux bornes du troisième dipôle 43. Le circuit de détection et de mesure 44 est configuré pour ouvrir et fermer alternativement l'interrupteur 45. Le circuit de détection et de mesure 44 mesure la tension aux bornes du dipôle 43 et est configuré pour en déduire la présence d'un défaut d'isolement, la polarité de ce défaut d'isolement et/ou l'amplitude de ce défaut d'isolement.

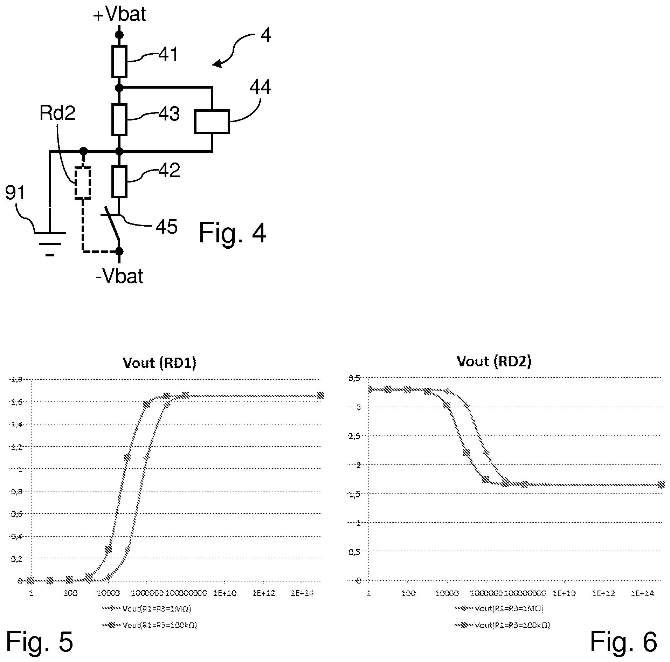

La figure 3 illustre le schéma électrique équivalent du dispositif 4, en présence d'un défaut d'isolement assimilable à une résistance Rd1 entre la borne +Vbat et la masse mécanique 91. La figure 4 illustre le schéma électrique équivalent du dispositif 4, en présence d'un défaut d'isolement assimilable à une résistance Rd2 entre la borne -Vbat et la masse mécanique 91. un tel dispositif 4 s'avère particulièrement approprié pour une batterie de puissance, dont la tension nominale est typiquement supérieure à 100V.

En pratique, la tension maximale aux bornes du dipôle 43 est atteinte en présence d'un court-circuit entre la masse mécanique 91 et la borne -Vbat. Afin de limiter la tension appliquée à l'entrée du circuit de détection et de mesure 4, la résistance du dipôle 41 est au moins 10 fois supérieure à la résistance du dipôle 43. Pour une plage de tension VoutMax souhaitée aux bornes du circuit 44, on peut déterminer R3 comme suit :

$$R3 = (R1 * VoutMax) / (Vbat - VoutMax)$$

VoutMax sera avantageusement inférieur ou égal à 3,5V pour permettre l'utilisation de composants électroniques d'usage courant et de coût réduit dans le circuit 44.

Par ailleurs, le dipôle 43 aux bornes duquel le circuit de détection et de mesure 44 est connecté est avantageusement connecté entre la masse 91 et la borne positive de la batterie 2, de sorte que le circuit de détection et de mesure 44 ne mesure que des tensions positives. Le circuit 44 permet de mesurer un défaut d'isolement pour les bornes de polarité opposées, et ce avec une tension de mesure Vout dont le signe reste inchangé.

Le dipôle 43 est avantageusement connecté à la masse mécanique 91. L'interrupteur 45 est avantageusement connecté à la masse mécanique 91.

Lorsque l'interrupteur 45 est fermé, en présence d'un défaut d'isolement Rd1 uniquement entre la borne +Vbat et la masse 91, la tension Vout appliquée aux bornes du circuit 44 vaut alors :

$$Vout = Vbat * \frac{R3}{R1+R3} * \frac{\dfrac{(R1+R3)*Rd1}{R1+R3+Rd1}}{\dfrac{(R1+R3)*Rd1}{R1+R3+Rd1}+R2}$$

Lorsque l'interrupteur 45 est fermé, en présence d'un défaut d'isolement Rd2 uniquement entre la borne -Vbat et la masse 91, la tension Vout appliquée aux bornes du circuit 44 vaut alors :

$$Vout = Vbat * \frac{R3}{R1+R3+\dfrac{R2*Rd2}{R2+Rd2}}$$

Dans ces deux cas de figure, on peut en déduire l'amplitude des défauts d'isolement :

$$Rd1 = -\frac{R2*(R1+R3)}{R1+R2+R3-\dfrac{Vbat*R3}{Vout}}$$

$$Rd2 = -\frac{R2*\left(\dfrac{Vbat*R3}{Vout}-R1-R3\right)}{R1+R2+R3-\dfrac{Vbat*R3}{Vout}}$$

La mesure de l'amplitude d'un défaut d'isolement est ainsi basée sur l'amplitude de la composante continue de la tension aux bornes du dipôle 43.

Les figures 5 et 6 illustrent la tension aux bornes du circuit de détection et de mesure 44 en fonction de l'amplitude des défauts d'isolement Rd1 ou Rd2, pour différentes valeurs des résistances des dipôles 41 et 42. Pour ces mesures, l'interrupteur 45 est fermé. Dans ces différents cas de figure, la résistance R1 est au moins 100 fois supérieure à la résistance R3. R3 est ici dimensionné de sorte que VoutMax=3,3V. Dans ces différents cas de figure, R1=R2.

Le diagramme montre que le circuit 44 comporte une plage de non détection de défaut d'isolement (défaut d'isolement de trop faible amplitude), une plage de mesure (une amplitude de défaut d'isolement peut être déterminée) et une plage de détection (un défaut d'isolement peut être identifié mais pas son amplitude).

On constate que l'augmentation des valeurs de R1 et R2 permet de détecter un défaut d'isolement plus tôt. L'augmentation des valeurs de R1 et R2 accroît également le seuil de transition entre la plage de mesure et la plage de détection. Par conséquent, les valeurs de R1 et R2 seront avantageusement choisies en fonction du seuil de transition entre la plage de mesure et la plage de non détection, et en fonction du domaine souhaité pour la plage de mesure.

En pratique, des ouvertures/fermetures alternées de l'interrupteur 45 permettent d'accroître le domaine de la plage de mesure du circuit 44. Des ouvertures/fermetures alternées de l'interrupteur 45 permettent en outre de détecter la présence simultanée de défauts d'isolement du côté de la borne -Vbat et du côté de la borne +Vbat. L'interrupteur 45 permet d'éviter une imprécision ou une absence de détection de défauts d'isolement par compensation des défauts d'isolement de part et d'autre de la masse mécanique 91.

Lorsque l'interrupteur 45 est fermé, la tension Vout1 aux bornes du dipôle 43 est donnée par la formule suivante :

$$Vout1 = Vbat * \frac{R3}{R1+R3} * \frac{\dfrac{(R1+R3)*Rd1}{R1+R3+Rd1}}{\dfrac{(R1+R3)*Rd1}{R1+R3+Rd1}+\dfrac{R2*Rd2}{R2+Rd2}}$$

Lorsque l'interrupteur 45 est ouvert, la tension Vout2 aux bornes du dipôle 43 est donnée par la formule suivante :

$$Vout2 = Vbat * \frac{R3}{R1+R3} * \frac{\dfrac{(R1+R3)*Rd1}{R1+R3+Rd1}}{\dfrac{(R1+R3)*Rd1}{R1+R3+Rd1} + R2}$$

On dispose ainsi d'un système de deux équations à deux inconnues, qui donne les solutions suivantes :

$$Rd1 = -\frac{R2*R13*[Vout2*(Vb3-R13*Vout1)-Vout1*(Vb3-R13*Vout2)]}{Vout1*R2(Vb3-R13*Vout2)-(Vb3-(R13-R2)Vout2)(Vb3-R13*Vout1)}$$

Avec

$$R13 = R1+R3 \text{ et } Vb3 = Vbat*R3$$

$$Rd2 = \frac{Rd1*(Vbat*R3-(R1+R3)*Vout2)}{Vout2*(R1+R3+Rd1)}$$

Par conséquent, tant qu'un défaut d'isolement d'un côté ou de l'autre de la masse mécanique 91 ne comporte pas une résistance inférieure au seuil de transition de la plage de détection, le circuit 44 est apte à fournir une mesure de l'amplitude des défauts d'isolement Rd1 et Rd2.
Lorsque l'interrupteur 45 est ouvert, en l'absence de défaut d'isolement la tension Vout1 est nulle. La consommation électrique des dipôles 41 à 43 est alors également nulle. La tension Vout1 augmente alors uniquement lors de l'apparition d'un défaut d'isolement Rd2.
Pour limiter la consommation durant la fermeture de l'interrupteur 45, celui-ci pourra être maintenu fermé avec un rapport cyclique inférieur ou égal à 2%. En outre, les résistances R1 et R2 seront avantageusement au moins égales à 50kΩ chacune. Les fermetures de l'interrupteur 45 peuvent être répétées avec un intervalle temporel compris entre 2 et 30 secondes.
Pour déterminer l'amplitude du défaut d'isolement, le circuit 44 peut réaliser un codage numérique de la tension Vout mesurée. On peut par exemple coder la mesure de tension Vout sur 12 bits par l'intermédiaire d'un échantillonneur à l'entrée du circuit 44. La taille du mot de codage sera bien entendue adaptée à la précision souhaitée pour la mesure.
Des tests ont été effectués avec des défauts d'isolement Rd1=50kΩ et Rd2=1MΩ, pour des résistances R1 et R2 de 1MΩ. Le circuit 44 a permis d'obtenir des mesures de Rd1 et Rd2 avec une erreur inférieure à 10%, avec un codage de la mesure Vout sur 12 bits, 10 bits ou 8 bits.
Des tests ont été effectués avec des défauts d'isolement Rd1=Rd2=100kΩ, pour des résistances R1 et R2 de 1MΩ. Le circuit 44 a permis d'obtenir des mesures de Rd1 et Rd2 avec une erreur inférieure à 2%, avec un codage de la mesure Vout sur 12 bits, 10 bits ou 8 bits.
Si un défaut apparaît à l'intérieur d'une des cellules incluses dans la batterie 2, les tensions Vbat et Vout vont varier. Un court-circuit avec la masse mécanique 91 au milieu de la connexion en série de cellules ne modifie pas le potentiel de la masse mécanique 91. Par contre, l'ouverture de l'interrupteur 45 permet d'identifier un tel court-circuit. En effet, en l'absence de court-circuit, on devrait avoir une tension Vout2 nulle. En présence d'un tel court circuit, on obtient une valeur

$$Vout2 = +Vbat * R3 / (R1 + R3)$$

On peut donc déterminer la présence d'un tel court-circuit du fait d'une déviation de Vout2 par rapport à la valeur attendue.
L'invention s'avère particulièrement avantageuse lorsque la résistance R1 est supérieure à la résistance R2, par exemple lorsque R1 est au moins égale à deux fois R2, de préférence lorsque R1 est au moins égale à trois fois R2.
En pratique, cela permet d'élargir sensiblement le domaine de la plage de mesure. En outre, une telle différence de résistance permet d'appliquer une tension proche de la tension Vbat entre chaque borne -Vbat et +Vbat de la batterie et la masse mécanique 91 pour tester la tenue de l'isolement. En l'absence de défaut d'isolement trop important, lorsque l'interrupteur 45 est ouvert, on applique sensiblement la tension Vbat entre la borne -Vbat et la masse mécanique 91. Lorsque l'interrupteur 45 est fermé, du fait de la différence entre les résistances R1 et R2, ont appliqué une tension proche de Vbat entre la borne +Vbat et la masse mécanique 91. Ces avantages sont obtenus sans induire de surcoût des composants du dispositif 4.

Du fait de cette importante différence de résistance, la variation de la tension Vout1 est accrue en l'absence de défaut d'isolement Rd2. En présence d'un défaut d'isolement Rd2, une faible valeur de la résistance R2 permet une plus grande sensibilité de mesure de ce défaut d'isolement Rd2.

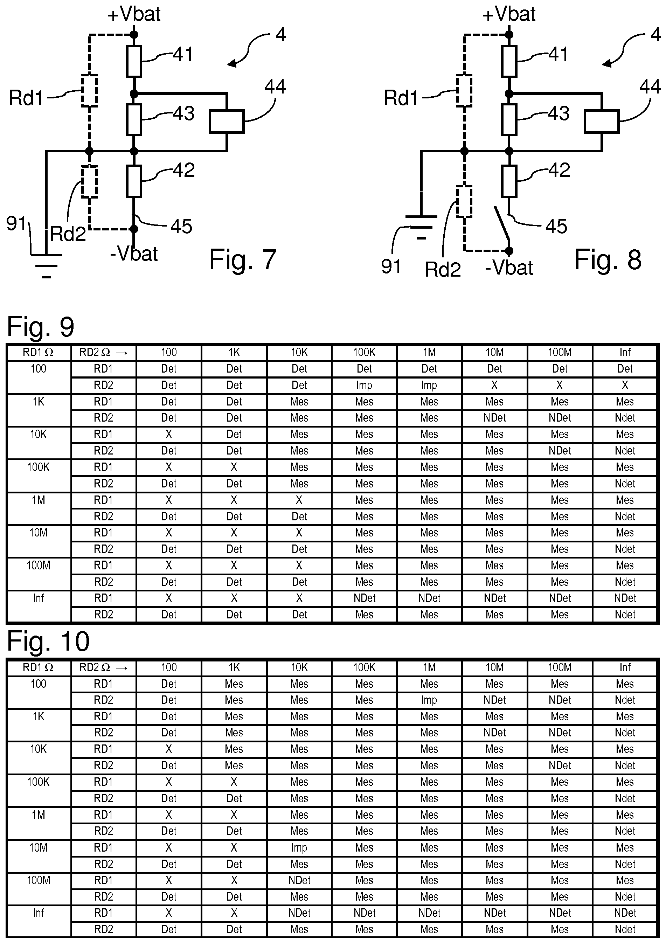

Les tableaux figures 9 et 10 correspondent à des simulations effectuées respectivement avec des résistances R1 et R2 identiques (1MΩ) et des résistances R1 et R2 différentes (1MΩ et 100kΩ respectivement). La mesure de tension Vout est codée sur 12 bits pour ces simulations.

Le tableau illustre les résultats pour différentes combinaisons de valeur des défauts d'isolement Rd1 et Rd2.

Les notations suivantes sont utilisées :

Mes : défaut d'isolement identifié et amplitude mesurée avec une erreur inférieure à 20 % ;
NDet : défaut d'isolement non identifié ;
Det : défaut d'isolement détecté mais non mesuré ou mesuré avec une erreur supérieure à 20 % ;
Imp : erreur de détection ou de non détection;
X : mesure impossible.

On constate qu'une mesure précise d'un défaut d'isolement présentant une faible résistance n'est pas effectuée mais une telle précision sur un tel défaut d'isolement n'est pas nécessaire car il s'agit d'un défaut d'isolement dont l'amplitude est quoi qu'il en soit grave.

On constate également que des valeurs différentes des résistances R1 et R2 permet d'obtenir une mesure précise dans un bien plus grand nombre de cas (mesures de défaut pour des résistances dix fois inférieures), un nombre de mesures impossibles réduit, et un nombre de détections erronées réduit. Dans tous les cas, le défaut d'isolement prépondérant est détecté.

L'utilisation d'une résistance R2 de plus faible valeur combinée à la présence de l'interrupteur 45 en série permet quoi qu'il en soit de limiter la consommation électrique du dispositif 4 tout en bénéficiant des avantages d'une telle différence entre les résistances R1 et R2. La résistance R2 présente avantageusement une valeur suffisamment élevée pour pouvoir mesurer précisément des défauts d'isolement Rd1 présentant des valeurs élevées de résistance.

Le dipôle 43 peut être mis en œuvre sous la forme d'un potentiomètre ou de résistances commutées dont la valeur de résistance est fixée par un circuit de commande proportionnelle à la tension Vbat aux bornes de la batterie 2. La mesure de défaut d'isolement pourra ainsi tenir compte de variations de charge de la batterie 2. La résolution de mesure peut ainsi être identique, quelle que soit la charge de la batterie 2. Le dipôle 43 peut par exemple être mis en oeuvre sous la forme d'un potentiomètre numérique. Un tel potentiomètre pourra comprendre un composant dont la résistance est fixe, en série avec un composant dont la résistance est variable, en fonction de la plage de valeur souhaitée pour la résistance R3. Avantageusement, les dipôles 41 et 42 peuvent être des potentiomètres. Ainsi, les domaines des plages de mesure pourront être modulés en jouant sur ces valeurs de résistance.

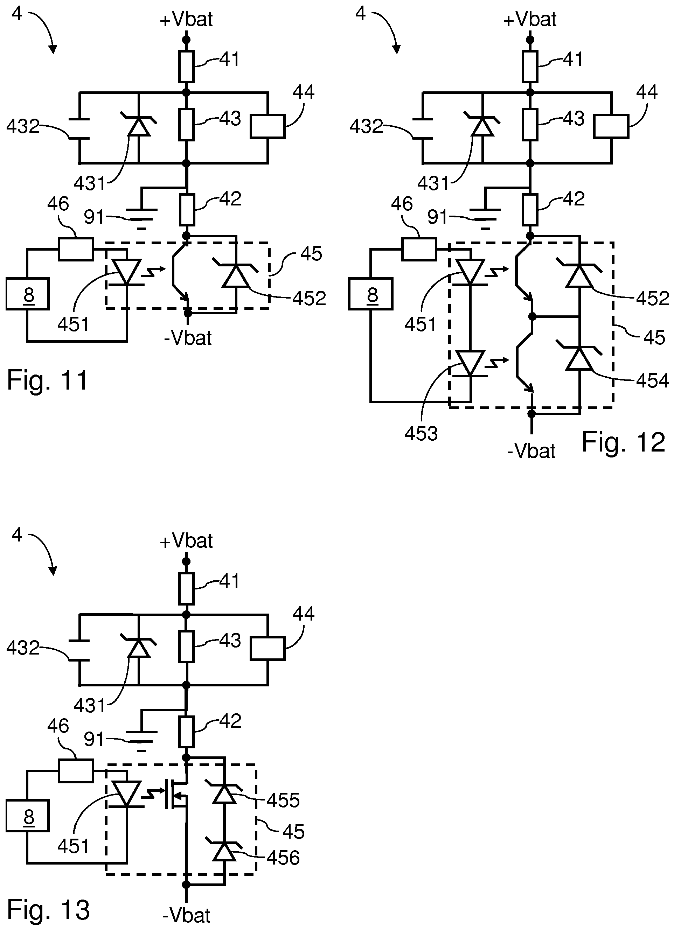

Les figures 11 à 13 illustrent différentes variantes de dispositifs de détection de défaut d'isolement, dans lesquelles l'interrupteur 45 inclut un optocoupleur. L'utilisation d'un optocoupleur permet d'isoler la commande de l'interrupteur 45 par rapport aux dipôles 41 à 43 aux bornes desquels une tension élevée est appliquée.

Dans ces différentes variantes, une diode Zener 431 est connectée en parallèle du troisième dipôle 43. Cette diode 431 permet d'éviter les surtensions sur le circuit 44 dans l'hypothèse d'un important défaut d'isolement. Dans ces différentes variantes, un condensateur 432 est connecté en parallèle du troisième dipôle 43. Le condensateur 432 permet de filtrer la tension aux bornes du dipôle 43 afin d'éliminer les perturbations hautes fréquences.

Dans la variante de la figure 11, l'interrupteur 45 inclut un unique optocoupleur 451. L'optocoupleur 451 utilise un phototransistor de type bipolaire. Une diode Zener 452 est connectée en parallèle de l'optocoupleur 451. L'optocoupleur 451 est utilisé en mode de saturation pour réaliser la fonction d'interrupteur. L'optocoupleur 451 est commandé par le circuit de commande 8 par l'intermédiaire d'une résistance 46. La diode Zener 452 protège l'optocoupleur 451 d'éventuelles surtensions pouvant provenir des éléments connectés à la batterie 2, par exemple un onduleur moteur durant le roulage ou un réseau électrique durant une recharge. La tension Zener de la diode 452 est inférieure à la tension VceMax de l'optocoupleur et supérieure à la tension Vbat. L'interrupteur 45 est ici normalement ouvert, la commande de l'interrupteur 45 ne consommant alors pas d'énergie au repos.

Dans la variante de la figure 12, l'interrupteur 45 inclut deux optocoupleurs 451 et 453 connectés en série. Un tel montage permet notamment d'utiliser des composants de puissance relativement courants, avec des batteries dont la tension Vbat nominale est supérieure à 400 V. Les optocoupleurs 451 et 453 utilisent des phototransistors de type bipolaires. Une diode Zener 452 est connectée en parallèle de l'optocoupleur 451 et une diode Zener 454 est connectée en parallèle de l'optocoupleur 453. La tension Zener des diodes 452 et 454 est supérieure à Vbat/2. Dans cet exemple, les diodes des optocoupleurs 452 et 454 sont connectées en série. Si la tension de commande n'est pas suffisante pour le pilotage des diodes en série, un circuit de commande parallèle peut être utilisé.

Dans la variante de la figure 13, l'interrupteur 45 inclut un optocoupleur 451 utilisant un phototransistor à effet de champ. Du fait d'une meilleure tenue en tension de ce type d'optocoupleur, un unique optocoupleur 451 peut être utilisé, même lorsque la tension Vbat est supérieure à 400 V. Pour de tels niveaux de tension, on utilise plusieurs diodes Zener 455 et 456 connectées en série, dans une branche connectée en parallèle du phototransistor de l'optocoupleur 451.

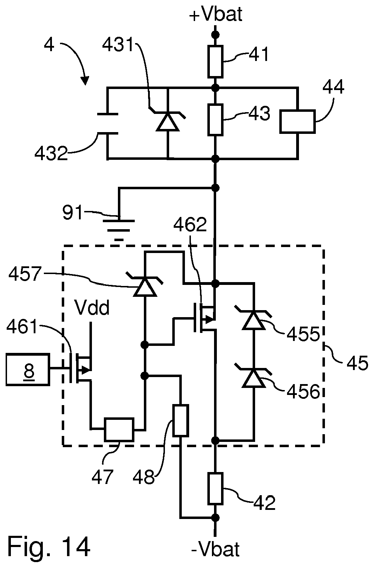

La figure 14 illustre une autre variante d'un dispositif de détection et de mesure 4, dans lequel la commande de l'interrupteur 45 peut ne pas être isolée des dipôles 41 à 43. Dans cet exemple, l'interrupteur 45 est connecté entre le dipôle 42 et la masse mécanique 91.

L'interrupteur 45 inclut un transistor PMos 462 connecté en série entre le dipôle 42 et la masse mécanique 91. Une branche connectée en parallèle du transistor 462 inclut deux diodes Zener 455 et 456 connectées en série. Une résistance 48 est connectée entre la borne -Vbat et la grille du transistor 462. Une diode Zener 457 est connectée entre la grille du transistor 462 et la masse mécanique 91. L'interrupteur 45 inclut en outre un transistor nMOS 461 dont la grille est contrôlée par le circuit de commande 8. Une tension d'alimentation Vdd est appliquée sur le drain du transistor 461, et une résistance 47 est connectée entre la source du transistor 461 et la grille du transistor 462.

Lorsque le transistor 461 est ouvert, la diode Zener 457 permet d'appliquer une tension négative sur la grille du transistor 462 pour l'amener à saturation. Lorsque le transistor 461 est fermé, la tension d'alimentation Vdd est appliquée sur la grille du transistor 462 et induit ainsi son blocage.

Pour une intégration dans un véhicule automobile 1, le contrôle d'un défaut d'isolement par le dispositif de détection et de mesure 4 peut être réalisé au démarrage du véhicule et/ou durant le roulage.

## Revendications

1. Dispositif de détection (4) d'un défaut d'isolement d'une source de tension continue susceptible d'induire une électrocution, comprenant :

   - des première et deuxième bornes d'entrée (-Vbat, +Vbat) destinées à être connectées aux bornes de la source de tension;
   - des premier et troisième dipôles résistifs (41, 43) connectés en série entre une masse électrique (91) et la deuxième borne d'entrée (+Vbat), le premier dipôle résistif (41) présentant une résistance au moins dix fois supérieure à celle du troisième dipôle (43) ;

   - une deuxième liaison électrique constituée d'un deuxième dipôle résistif (42) et d'un interrupteur (45) connectés en série entre la première borne d'entrée (-Vbat) et la masse électrique (91), ladite deuxième liaison électrique étant connectée directement à la première borne d'entrée d'une part et à la masse électrique d'autre part, la résistance du premier dipôle (41) étant au moins trois fois supérieure à la résistance du deuxième dipôle (42);

   - un circuit de détection (44) connecté aux bornes du troisième dipôle (43), le circuit de détection étant configuré pour :

      - ouvrir et fermer alternativement ledit interrupteur ;
      - mesurer la tension aux bornes du troisième dipôle lorsque l'interrupteur est ouvert et lorsque l'interrupteur est fermé ;
      - déterminer l'amplitude d'un défaut d'isolement en fonction des tensions mesurées.

2. Dispositif de détection selon la revendication 1, dans lequel le troisième dipôle (43) est un potentiomètre ou un réseau de résistances commutées.

3. Dispositif de détection selon la revendication 1 ou 2, dans lequel le circuit de détection (44) ferme ledit interrupteur (45) de façon répétée avec un intervalle temporel compris entre 2 et 30 secondes.

4. Dispositif de détection selon l'une quelconque des revendications précédentes, dans lequel le circuit de détection (44) maintient l'interrupteur (45) fermé avec un rapport cyclique inférieur ou égal à 2 %.

**5.** Dispositif de détection selon l'une quelconque des revendications précédentes, dans lequel ledit interrupteur inclut un optocoupleur (451) commandé par le circuit de détection (44).

**6.** Dispositif de détection selon l'une quelconque des revendications précédentes, dans lequel la résistance du premier dipôle et la résistance du deuxième dipôle sont chacune au moins égales à 50kΩ.

**7.** Système de motorisation, comprenant :

- un dispositif de détection (4) selon l'une quelconque des revendications précédentes ;
- une batterie (2) dont les bornes sont connectées aux première et deuxième bornes d'entrée du dispositif de détection ;
- un onduleur (6) présentant une interface continu et une interface alternatif, les bornes de la batterie étant connectées à l'interface continu ;
- un moteur électrique (7) connecté à l'interface alternatif de l'onduleur (6).

**8.** Système de motorisation selon la revendication 7, dans lequel la tension aux bornes de la batterie (2) est supérieure à 100 V.

**9.** Système de motorisation selon la revendication 7 ou 8, incluant un dispositif de détection selon la revendication 2, dans lequel le circuit de détection (44) commande la résistance du potentiomètre (43) de sorte que cette résistance est proportionnelle à la tension aux bornes de la batterie (2).

**Patentansprüche**

**1.** Vorrichtung zum Nachweis (4) eines Isolationsfehlers einer Gleichspannungsquelle, der geeignet ist, einen tödlichen elektrischen Schlag zu verursachen, umfassend:

- einen ersten und zweiten Eingangsanschluss (-Vbat, +Vbat), die dazu bestimmt sind, an die Anschlüsse der Spannungsquelle angeschlossen zu sein;
- einen ersten und dritten resistiven Zweipol (41, 43), die zwischen einer elektrischen Masse (91) und dem zweiten Eingangsanschluss (+Vbat) in Reihe geschaltet sind, wobei der erste resistive Zweipol (41) einen Widerstand aufweist, der mindestens zehnmal höher als jener des dritten Zweipols (43) ist;
- eine zweite elektrische Verbindung, die von einem zweiten resistiven Zweipol (42) und einem Schalter (45) gebildet ist, die zwischen dem ersten Eingangsanschluss (-Vbat) und der elektrischen Masse (91) in Reihe geschaltet sind, wobei die zweite elektrische Verbindung direkt an den ersten Eingangsanschluss einerseits und die elektrische Masse andererseits angeschlossen ist, wobei der Widerstand des ersten Zweipols (41) mindestens dreimal höher als der Widerstand des zweiten Zweipols (42) ist;
- eine Nachweisschaltung (44), die an die Anschlüsse des dritten Zweipols (43) angeschlossen ist, wobei die Nachweisschaltung dazu ausgebildet ist:
- den Schalter abwechselnd zu öffnen und zu schließen;
- die Spannung an den Anschlüssen des dritten Zweipols zu messen, wenn der Schalter geöffnet ist und wenn der Schalter geschlossen ist;
- die Amplitude eines Isolationsfehlers in Abhängigkeit von den gemessenen Spannungen zu bestimmen.

**2.** Nachweisvorrichtung nach Anspruch 1, wobei der dritte Zweipol (43) ein Potentiometer oder ein Netzwerk aus geschalteten Widerständen ist.

**3.** Nachweisvorrichtung nach Anspruch 1 oder 2, wobei die Nachweisschaltung (44) den Schalter (45) mit einem Zeitintervall zwischen 2 und 30 Sekunden wiederholt schließt.

**4.** Nachweisvorrichtung nach einem der vorhergehenden Ansprüche, wobei die Nachweisschaltung (44) den Schalter (45) mit einem Tastverhältnis kleiner oder gleich 2 % geschlossen hält.

**5.** Nachweisvorrichtung nach einem der vorhergehenden Ansprüche, wobei der Schalter einen Optokoppler (451) aufweist, der durch die Nachweisschaltung (44) gesteuert wird.

**6.** Nachweisvorrichtung nach einem der vorhergehenden Ansprüche, wobei der Widerstand des ersten Zweipols und der Widerstand des zweiten Zweipols jeweils mindestens gleich 50 kΩ sind.

7. Motorisierungssystem, umfassend:

- eine Vorrichtung (4) nach einem der vorhergehenden Ansprüche;
- eine Batterie (2), deren Anschlüsse an den ersten und zweiten Eingangsanschluss der Nachweisvorrichtung angeschlossen sind;
- einen Wechselrichter (6), der eine Gleichspannungs-Schnittstelle und eine Wechselspannungs-Schnittstelle aufweist, wobei die Anschlüsse der Batterie an die Gleichspannungs-Schnittstelle angeschlossen sind;
- einen Elektromotor (7), der an die Wechselspannungs-Schnittstelle des Wechselrichters (6) angeschlossen ist.

8. Motorisierungssystem nach Anspruch 7, wobei die Spannung an den Anschlüssen der Batterie (2) höher als 100 V ist.

9. Motorisierungssystem nach Anspruch 7 oder 8, aufweisend eine Nachweisvorrichtung nach Anspruch 2, wobei die Nachweisschaltung (44) den Widerstand des Potentiometers (43) so steuert, dass dieser Widerstand zur Spannung an den Anschlüssen der Batterie (2) proportional ist.

**Claims**

1. Device (4) for detecting an insulation fault of a DC voltage source liable to induce an electrocution, comprising

- first and second input terminals (-Vbat, +Vbat) intended to be connected to the terminals of the voltage source;
- first and third resistive dipoles (41, 43) connected in series between an electrical ground (91) and the second input terminal (+Vbat), the first resistive dipole (41) having a resistance at least ten times greater than that of the third dipole (43);

- a second electrical connection consisting of a second resistive dipole (42) and a switch (45), which are connected in series between the first input terminal (-Vbat) and the electrical ground (91), said second electrical connection being connected directly to the first input terminal on the one hand and to the electrical ground on the other hand, the resistance of the first dipole (41) being at least three times greater than the resistance of the second dipole (42);

- a detection circuit (44) connected to the terminals of the third dipole (43), the detection circuit being configured in order to:

- open and close said switch alternately;
- measure the voltage across the terminals of the third dipole when the switch is open and when the switch is closed;
- determine the amplitude of an insulation fault as a function of the voltages measured.

2. Detection device according to Claim 1, wherein the third dipole (43) is a potentiometer or a network of switched resistors.

3. Detection device according to Claim 1 or 2, wherein the detection circuit (44) closes said switch (45) repeatedly with a time interval between 2 and 30 seconds.

4. Detection device according to any one of the preceding claims, wherein the detection circuit (44) keeps the switch (45) closed with a duty cycle of less than or equal to 2%.

5. Detection device according to any one of the preceding claims, wherein said switch includes an optocoupler (451) controlled by the detection circuit (44) .

6. Detection device according to any one of the preceding claims, wherein the resistance of the first dipole and the resistance of the second dipole are each at least equal to 50 kΩ.

7. Motorization system comprising:

- a detection device (4) according to any one of the preceding claims;
- a battery (2), the terminals of which are connected to the first and second input terminals of the detection device;
- an inverter (6) having a DC interface and an AC interface, the terminals of the battery being connected to the DC interface;
- an electric motor (7) connected to the AC interface of the inverter (6).

8. Motorization system according to Claim 7, wherein the voltage across the terminals of the battery (2) is greater than 100 V.

9. Motorization system according to Claim 7 or 8, including a detection device according to Claim 2, wherein the detection circuit (44) controls the resistance of the potentiometer (43) so that this resistance is proportional to the voltage across the terminals of the battery (2).

Fig. 1

+Vbat

21

2

93

-Vbat

3

4

5

91

51

1

52

8

92

91

7

6

+Vbat

41

43

44

42

45

91

-Vbat

Fig. 2

4

+Vbat

Rd1

41

43

44

42

45

91

-Vbat

Fig. 3

4

Fig. 4

Vout (RD1)

Vout(R1=R3=1MΩ)
Vout(R1=R3=100kΩ)

Fig. 5

Vout (RD2)

Vout(R1=R3=1MΩ)
Vout(R1=R3=100kΩ)

Fig. 6

Fig. 7

Fig. 8

## Fig. 9

| RD1 Ω | RD2 Ω → | 100 | 1K | 10K | 100K | 1M | 10M | 100M | Inf |
|---|---|---|---|---|---|---|---|---|---|
| 100 | RD1 | Det | Det | Det | Det | Det | Det | Det | Det |
|  | RD2 | Det | Det | Det | Imp | Imp | X | X | X |
| 1K | RD1 | Det | Det | Mes | Mes | Mes | Mes | Mes | Mes |
|  | RD2 | Det | Det | Mes | Mes | Mes | NDet | NDet | Ndet |
| 10K | RD1 | X | Det | Mes | Mes | Mes | Mes | Mes | Mes |
|  | RD2 | Det | Det | Mes | Mes | Mes | Mes | NDet | Ndet |
| 100K | RD1 | X | X | Mes | Mes | Mes | Mes | Mes | Mes |
|  | RD2 | Det | Det | Mes | Mes | Mes | Mes | Mes | Ndet |
| 1M | RD1 | X | X | X | Mes | Mes | Mes | Mes | Mes |
|  | RD2 | Det | Det | Det | Mes | Mes | Mes | Mes | Ndet |
| 10M | RD1 | X | X | X | Mes | Mes | Mes | Mes | Mes |
|  | RD2 | Det | Det | Det | Mes | Mes | Mes | Mes | Ndet |
| 100M | RD1 | X | X | X | Mes | Mes | Mes | Mes | Mes |
|  | RD2 | Det | Det | Det | Mes | Mes | Mes | Mes | Ndet |
| Inf | RD1 | X | X | X | NDet | NDet | NDet | NDet | NDet |
|  | RD2 | Det | Det | Det | Mes | Mes | Mes | Mes | Ndet |

## Fig. 10

| RD1 Ω | RD2 Ω → | 100 | 1K | 10K | 100K | 1M | 10M | 100M | Inf |
|---|---|---|---|---|---|---|---|---|---|
| 100 | RD1 | Det | Mes | Mes | Mes | Mes | Mes | Mes | Mes |
|  | RD2 | Det | Mes | Mes | Mes | Imp | NDet | NDet | Ndet |
| 1K | RD1 | Det | Mes | Mes | Mes | Mes | Mes | Mes | Mes |
|  | RD2 | Det | Mes | Mes | Mes | Mes | NDet | NDet | Ndet |
| 10K | RD1 | X | Mes | Mes | Mes | Mes | Mes | Mes | Mes |
|  | RD2 | Det | Mes | Mes | Mes | Mes | Mes | NDet | Ndet |
| 100K | RD1 | X | X | Mes | Mes | Mes | Mes | Mes | Mes |
|  | RD2 | Det | Det | Mes | Mes | Mes | Mes | Mes | Ndet |
| 1M | RD1 | X | X | Mes | Mes | Mes | Mes | Mes | Mes |
|  | RD2 | Det | Det | Mes | Mes | Mes | Mes | Mes | Ndet |
| 10M | RD1 | X | X | Imp | Mes | Mes | Mes | Mes | Mes |
|  | RD2 | Det | Det | Mes | Mes | Mes | Mes | Mes | Ndet |
| 100M | RD1 | X | X | NDet | Mes | Mes | Mes | Mes | Mes |
|  | RD2 | Det | Det | Mes | Mes | Mes | Mes | Mes | Ndet |
| Inf | RD1 | X | X | NDet | NDet | NDet | NDet | NDet | NDet |
|  | RD2 | Det | Det | Mes | Mes | Mes | Mes | Mes | Ndet |

Fig. 11

Fig. 12

Fig. 13

Fig. 14

**RÉFÉRENCES CITÉES DANS LA DESCRIPTION**

**Documents brevets cités dans la description**

- WO 2012036498 A2
- US 2004212371 A1